# EUROPEAN PATENT APPLICATION

(11) **EP 4 700 796 A1**
(43) Date of publication of application: **25.02.2026**
(21) Application number: 25196928.3
(22) Date of filing: 20.08.2025
(51) Int. Cl.: G21H 1/06

(54) **STACK-TYPE ISOTOPE BATTERY**

(30) Priority: 20.08.2024 KR 20240111556; 19.08.2025 KR 20250114971
(71) Applicant: LG Energy Solution, Ltd., Seoul 07335 (KR)
(72) Inventor: KIM, Dong Myung, Daejeon 34122 (KR); KIM, Je Young, Daejeon 34122 (KR); SHIN, Dong Myung, Daejeon 34122 (KR)
(74) Representative: BCKIP Part mbB

(57) **Abstract**

A stack-type isotope battery comprises: a plurality of stacked isotope electrode sheets, each of the isotope electrode sheets including: a substrate having a first layer and a second layer and a cavity extending in the substrate thickness direction; and a radiation source accommodated in the cavity, wherein the first layer is interposed between the radiation source and the second layer, wherein the plurality of isotope electrode sheets are stacked on top of one another in a direction parallel to the substrate thickness direction; and a first external electrode of first polarity and a second external electrode of second polarity respectively connected to the plurality of stacked isotope electrode sheets to provide an electrical connection to an external load. The substrate has a chemical formula of AMO₃ (where A is one or more selected from the group consisting of La, Ba, Sr, and K, and M is one or more selected from the group consisting of Al, In, Ga, Ti, Sn, Hf, Ta, and Zr). The first layer is doped with dopants of a first conductive type and a second layer is either doped with dopants of a second conductive type different from the first conductive type or undoped.

## Description

### [Technical Field]

The present invention relates to a stack-type isotope battery.

### [Background]

Radiation emitted by radioactive isotopes can be absorbed through the surface of a p-n junction semiconductor and converted into electrical energy. The radiation generates electron-hole pairs in the space charge region of the p-n junction semiconductor, and the carriers generated in the process have voltage-current characteristics.

### [Summary of the invention]

It is an object of the present invention to provide a stack-type isotope battery that can generate electrical energy with high energy density.

It is another object of the present invention to provide a stack-type capacitor that can generate electrical energy with high energy density.

To accomplish the above technical problems, the present invention provides an isotope battery in accordance with independent claim 1. Further preferred features are defined in dependent claims.

A stack-type isotope battery according to the present invention comprises: a plurality of stacked isotope electrode sheets. Each of the isotope electrode sheets may include: a substrate having a first layer and a second layer and a cavity extending in the substrate thickness direction; and a radiation source accommodated in the cavity. Herein the first layer may be interposed between the radiation source and the second layer. The plurality of isotope electrode sheets may be stacked on top of one another in a direction parallel to the substrate thickness direction. The stack-type isotope battery may further comprise a first external electrode of first polarity and a second external electrode of second polarity respectively connected to the plurality of stacked isotope electrode sheets to provide an electrical connection to an external load. The substrate may have a chemical formula of AMO₃ (where A is one or more selected from the group consisting of La, Ba, Sr, and K, and M is one or more selected from the group consisting of Al, In, Ga, Ti, Sn, Hf, Ta, and Zr). The first layer may be doped with dopants of a first conductive type and a second layer may be either doped with dopants of a second conductive type different from the first conductive type or undoped.

Preferably, the substrate may have as a main component thereof one or more selected from the group consisting of BaSnO₃, BaHfO₃, BaZrO₃, BaHf₁₋ₓTiₓO₃(where 0<x<1), Ba₁₋ₓLaₓSnO₃(where 0<x<1), Bi₄Ge₃O₁₂, Al₂O₃, Y₂O₃, La₂O₃, Ga₂O₃, Bi₂O₃, ZrO₂, HfO₂, Ta₂O₅, TiO₂, LaInO₃, LaGaO₃, SrZrO₃, SrHfO₃, SrTaO₇, LaIn₁₋ₓGaₓO₃ (where 0<x<1), LaGaO₃, SrTiO₃, KTaO₃, HfSiO₄, Ta₃Ti₂Oₓ, and LaAlO₃.

Further, the substrate may have BaSnO₃ as the main component.

Furthermore, the first layer and the second layer may form a homojunction.

Optionally, the first layer may at least partially surround a periphery of the radiation source and the second layer may at least partially surround a periphery of the first layer.

Moreover, the cavity may be a through-hole penetrating the substrate.

Possibly, the cavity may have, on a top major surface of the substrate, a longitudinal extension substantially greater than a width thereof.

Desirably, the cavity may be provided in plurality.

The plurality of stacked isotope electrode sheets may have an identical configuration, being obtained from identical semiconductor dies.

Furthermore, the plurality of stacked isotope electrode sheets may be electrically connected to one another by solder balls.

The stack-type isotope battery according to the present invention may further comprise a controller chip provided on a side of the plurality of stacked isotope electrode sheets, being configured for controlling output of electrical energy generated from the plurality of stacked isotope battery sheets.

Optionally, the plurality of stacked isotope electrode sheets may be embedded in a molding resin.

Possibly, the stack-type isotope battery may further comprise at least one dummy electrode exposed outside through the molding resin.

The stack-type isotope battery may further comprise a first electrode and a second electrode provided in-between two neighboring ones of the plurality of stacked isotope electrode sheets. The first electrode may be arranged to provide electrical connection between corresponding first layers of the two neighboring isotope electrode sheets. The second electrode may be arranged to provide electrical connection between corresponding second layers of the two neighboring isotope electrode sheets.

Preferably, the cavity may include a stepped recess having a first recess at a top major surface of the substrate, and a through hole running from a bottom surface of the first recess toward a bottom major surface of the substrate. More preferably, the radiation source may comprise a first portion disposed in the first recess, and a second portion in the through hole.

The stack-type isotope battery in accordance with the present invention have the effect of generating electrical energy with high energy density.

The effects obtainable by the present invention are not limited to the above-mentioned effects, and other effects not mentioned can be clearly derived and understood by a person with ordinary skill in the art to which the following description belongs from the exemplary embodiments contained in the present disclosure. In other words, unintended effects resulting from the implementation of the exemplary embodiments of the present invention can also be derived by a person with ordinary knowledge in the art from the exemplary embodiments of the present invention.

### [Brief Description of the Drawings]

FIG. 1 is a side cross-sectional view of an isotope battery according to one embodiment of the present invention.
FIG. 2a and FIG. 2b are partial enlarged views around the radiation source of the isotope electrode sheet in detail, respectively.
FIG. 3a is a plan view of an isotope electrode sheet according to an embodiment of the invention
FIG. 3b is a plan view of an isotope electrode sheet of an isotope battery according to a further embodiment of the invention.
FIG. 3c is a plan view of an isotope electrode sheet of an isotope battery according to a further embodiment of the invention.
FIG. 4a is a plan view of an isotope electrode sheet of an isotope battery according to a still further embodiment of the invention.
FIG. 4b is a plan view of an isotope electrode sheet of an isotope battery according to a further embodiment of the invention.
FIG. 5 is a side cross-sectional view showing another isotope battery according to another embodiment of the present invention.
FIG. 6 to FIG. 8a are side cross-sectional views showing a further isotope battery according to further embodiments of the present invention, respectively.
FIG. 8b is a plan view of an isotope electrode sheet of the isotope battery of FIG. 8a.
FIG. 8c is a cross-sectional view along line X-X of FIG. 8b.
FIG. 9 is a side cross-sectional view illustrating an isotope battery according to another embodiment of the present invention.
FIG. 10a is a side cross-sectional view of an isotope battery according to an embodiment of the present invention.
FIG. 10b is a perspective view of the first doping layer, radiation source, and insulating layer of an isotope electrode sheet according to an embodiment of the present invention.
FIG. 11 is a side cross-sectional view illustrating an isotope battery according to another embodiment of the present invention.
FIG. 12a to FIG. 12h are side views showing a manufacturing method of an isotope battery according to an embodiment of the present invention.
FIG. 13 is a side cross-sectional view showing an isotope battery according to another further embodiment of the present invention.

### [Detailed Description of Exemplary Embodiments]

Hereafter, the preferred embodiments of the present invention will be described in detail with reference to the accompanying drawings. However, the embodiments of the concept of the present invention may be modified in various other forms, and the scope of protection should not be construed as being limited to the embodiments described below. It is desirable that the embodiments of the present invention be construed as being provided to more fully explain the concept of the present invention to a person with average knowledge in the industry. The same symbols mean the same elements throughout. Furthermore, the various elements and areas in the drawings are depicted schematically. Therefore, the concept of the present invention is not limited by the relative sizes or spacings depicted in the accompanying drawings.

The terms 'first,' 'second,' etc. may be used to describe various components, but the components are not limited by the terms. The terms are used only to distinguish one component from another. For example, the first component may be named the second component and vice versa, without falling outside the scope of the present invention.

The terms used in this application are used merely to describe specific embodiments and are not intended to limit the scope of the present invention. Singular expressions include plural expressions unless the context clearly indicates otherwise. In this application, the expressions 'comprising' or 'having' are to be understood as designating the presence of features, numbers, steps, actions, components, sub-components, or combinations thereof as described in the specification, but not as precluding the existence or addition of one or more other features, numbers, actions, components, sub-components, or combinations thereof.

Unless otherwise defined, all terms used herein, including technical terms and scientific terms, have the same meaning as commonly understood by a person of ordinary skill in the technical field to which the concept of the present invention belongs. It will also be understood that terms that are commonly used and defined in dictionaries should be interpreted as having a meaning consistent with their meaning in the context of the relevant technology, and should not be interpreted in an overly formal sense unless explicitly defined here.

In the event that a different embodiment is otherwise possible, a specific process sequence may be performed differently from the sequence described. For example, two processes described in succession may be performed substantially simultaneously, or in the reverse order of the sequence described.

In the accompanying drawings, for example, variations of the shapes shown may be expected depending on the manufacturing technology and/or tolerances. Therefore, the embodiments of the present invention should not be construed as being limited to the specific shapes of the areas shown in the specification, but should include, for example, changes in shape caused by the manufacturing process. All terms used herein 'and/or' include each of the components mentioned and all combinations of one or more of them. In addition, the term 'substrate' used in this specification may refer to the substrate itself or a laminated structure including a predetermined layer or film formed on the substrate and its surface. In addition, the term 'surface of the substrate' in this specification may refer to the exposed surface of the substrate itself or the outer surface of a predetermined layer or film formed on the substrate.

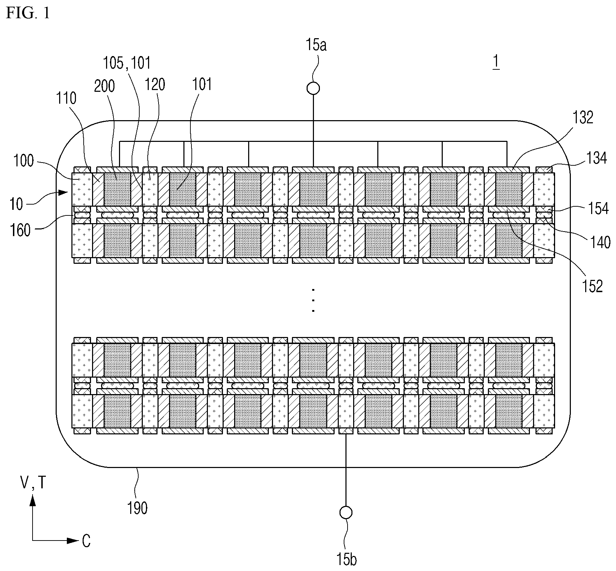

FIG. 1 is a side cross-sectional view exemplarily illustrating a stack-type isotope battery 1.

As shown in FIG. 1, the stack-type isotope battery 1 may include a plurality of isotope electrode sheets 10 stacked on top of one another in a vertical direction V, or a substrate thickness direction.

Each of the plurality of isotope electrode sheets 10 may include a substrate 100 and at least one radiation source 200.

The substrate 100 may comprise a first surface and a second surface positioned opposite to the first surface in a substrate thickness direction T. The first surface and the second surface may be the top and bottom major surfaces of the substrate 100, respectively. The substrate 100 may include a first doping layer 110 disposed on a side of the radiation source 200 and a second doping layer 120 disposed on a side of the first doping layer 110.

Generally, as schematically shown in FIG. 1, the first doping layer 110 and the second doping layer 120 may be arranged adjacent to one another. The first doping layer 110 and the second doping layer 120 may be repeatedly and/or alternately disposed along the direction the first and the second surface of the substrate 100 extends, or in other words, in a substrate transverse direction C which is perpendicular to the substrate thickness direction T. For example, the first doping layer 110 and the second doping layer 120 may form an interface extending in the substrate thickness direction T. At the interface, the first doping layer 110 and the second doping layer 120 may form a p-n-junction.

The radiation source 200 may be disposed in the substrate 100. For example, the radiation source 200 may extend all through the substrate, e.g., from the first - or top major - surface to the second - or bottom major - surface in the substrate thickness direction T. To this end, the radiation source 200 may be disposed in a cavity 105 formed in the first surface of the substrate 100. The cavity 105 may extend from the first surface toward the second surface of the substrate 100, and optionally, all the way till the second surface of the substrate 100, as exemplarily shown in FIG. 1.

For example, the radiation source 200 may partially or completely fill the cavity 105. Preferably, the radiation source 200 is in contact with the circumference of the cavity 105.

The substrate 100 may be a non-conductor (insulator, in other words) or a semiconductor.

The substrate 100 may include, for example, III-V group semiconductor materials. The III-V group semiconductor materials may include at least one of InAlP, InGaP, InAlGaP, ZnSe, AlAs, AlAsP, or yttria-stabilized zirconia (YSZ).

The substrate 100 may include a diamond substrate, a SiC substrate, a GaN substrate, a Bi₂O₃/GeO₂ substrate, a Sm₂O₃Bi₂O₃/GeO₂ substrate, a Sm₂O₃Bi₂O₃B₂O₃ substrate, Sm₂O₃/Bi₂O₃/GeO₂/B₂O₃ substrate, sapphire substrate, or a combination thereof, and may be undoped substrates.

Otherwise, the substrate 100 may include a diamond substrate, a SiC substrate, a GaN substrate, a Bi₂O₃/GeO₂ substrate, a Sm₂O₃Bi₂O₃/GeO₂ substrate, a Sm₂O₃/Bi₂O₃/B₂O₃ substrate, Sm₂O₃/Bi₂O₃/GeO₂/B₂O₃ substrate, sapphire substrate, or a combination thereof, and may be doped with a dopant.

The substrate 100 may include a metal oxide having a bandgap energy of 2.7 eV or more. Metal oxides are not only stable in high temperature and high humidity environments, but they also have high carrier mobility, so that they can efficiently absorb radiation emitted from the radiation source 200 and/or photons emitted from the subsequently described photon generating layer 250, thereby providing high energy conversion efficiency. In addition, there is no inelastic collision in carrier movement; as a result, there is no energy loss, achieving favorable heat dissipation. For example, the metal oxide may have carrier mobility of 45 cm²/(V·s) or higher, 80 cm²/(V·s) or higher, 120 cm²/(V·s) or higher, and even 300 cm²/(V·s) or higher.

These metal oxides are materials that can be doped in any conductive type and have the advantage of being able to provide high current or high voltage depending on the direction of the applied bias.

Optionally, the substrate 100 may include a metal oxide having the formula AMO₃ (where A is at least one selected from the group consisting of La, Ba, Sr, and K, and M is at least one selected from the group consisting of Al, In, Ga, Ti, Sn, Hf, Ta, and Zr).

Specifically, the substrate 100 may include one or more selected from a group consisting of BaSnO₃, BaHfO₃, BaZrO₃, BaHf₁₋ₓTiₓO₃ (where 0<x<1), Ba₁₋ₓLaₓSnO₃ (where 0<x<1), Bi₄Ge₃O₁₂, Al₂O₃, Y₂O₃, La₂O₃, Ga₂O₃, Bi₂O₃, ZrO₂, HfO₂, Ta₂O₅, TiO₂, LaInO₃, LaGaO₃, SrZrO₃, SrHfO₃, SrTaO₇, LaIn₁₋ₓGaₓO₃ (where 0<x<1), LaGaO₃, SrTiO₃, KTaO₃, HfSiO₄, Ta₃Ti₂Oₓ, and LaAlO₃ (where 0<x<1).

The substrate 100 may include at least one selected from a group consisting of BaSnO₃, BaHfO₃, BaZrO₃, BaHf₁₋ₓTiₓO₃ (where 0<x<1), Ba₁₋ₓLaₓSnO₃ (where 0<x<1), Bi₄Ge₃O₁₂, Al₂O₃, Y₂O₃, La₂O₃, Ga₂O₃, Bi₂O₃, ZrO₂, HfO₂, Ta₂O₅, TiO₂, LaInO₃, LaGaO₃, SrZrO₃, SrHfO₃, SrTaO₇, LaIn₁₋ₓGaₓO₃ (where 0<x<1), LaGaO₃, SrTiO₃, KTaO₃, HfSiO₄, Ta₃Ti₂Oₓ, and LaAlO₃ (where 0<x<1) as a major component. As used herein, "major component" means that the component counts for more than 50 wt% of the total weight.

For example, the substrate 100 may have BaSnO₃ as a major component.

The substrate 100 may be substantially electrically non-conductive in portions that are not doped with dopants. The portion of the substrate 100 doped with p-type dopants or n-type dopants may behave as an electrical conductor or semiconductor.

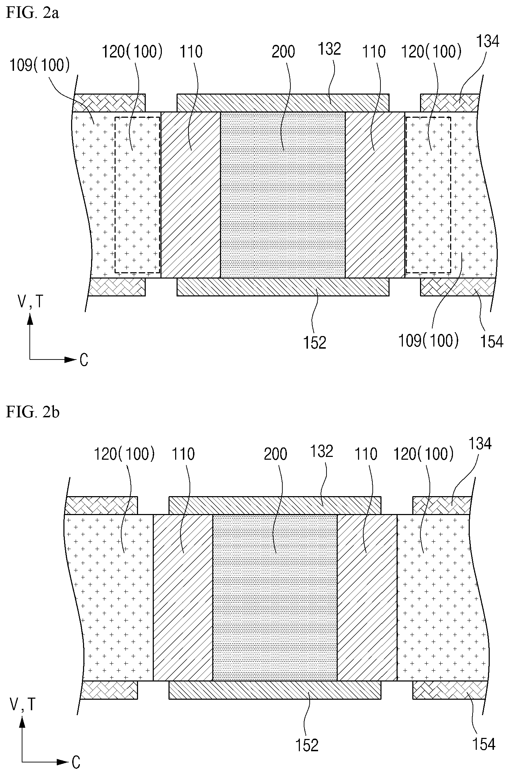

FIGS. 2a and 2b are partial enlarged views detailing the surroundings of the radiation source 200 of the isotope electrode sheet 10, respectively.

Referring to FIG. 2a, the radiation source 200 may extend in the thickness direction T of the substrate 100. While the radiation source 200 is exemplarily shown in FIG. 2a as penetrating the substrate 100 in the thickness direction T, or in other words, extending along the entire thickness of the substrate 100, the present invention is not limited to this.

The first doping layer 110 and the second doping layer 120 can generate electron-hole pairs by radiation emitted by the radiation source 200. For example, the first doping layer 110 and the second doping layer 120 may be arranged in an inorganic layer, an organic layer, a dye sensitized layer, or a combination thereof, and may generate power by forming electron-hole pairs by radiation.

The substrate 100 may include a concave part, i.e., the cavity 105. Optionally, the cavity 105 may be a hole or a trench. The concave part may have a certain extension between the two major surfaces of the substrate 100. The concave part may completely penetrate the substrate 100, that is, extend along the entire length between the top major surface and the bottom major surface of the substrate 100, or may only partially penetrate the substrate 100.

The first doping layer 110 may be disposed to at least partially surround the sides of the radiation source 200. The first doping layer 110 may be disposed to form an interface with the substrate 100. The first doping layer 110 may be disposed at least partially within the cavity 105. Optionally, the first doping layer 110 may be disposed completely within the cavity 105.

The first doping layer 110 may be a material having a higher electrical conductivity compared to the substrate 100. Optionally, the first doping layer 110 may include a material having a smaller bandgap than the substrate 100. For example, the first doping layer 110 may include a material having a bandgap of about 2.7 eV or greater, about 3.0 eV or greater, or about 3.5 eV or greater.

The radiation source 200 may be positioned within the substrate 100. Generally, the radiation source 200 may be disposed within the cavity 105, spaced apart from the interface. Optionally, the radiation source 200 may be spaced apart from the interface within the substrate 100.

Exemplarily, the first doping layer 110 may be provided conformally within the cavity 105. In this case, the first doping layer 110 may have a recess, in which the radiation source 200 may be disposed.

Optionally, the radiation source 200 may penetrate the substrate 100, that is, extend along the entire thickness of the substrate 100, from the top major surface to the bottom major surface. Otherwise, the radiation source 200 may only partially penetrate the substrate 100. The first doping layer 110 may be interposed between the substrate 100 and the radiation source 200. Specifically, the first doping layer 110 may be disposed on a side of the radiation source 200, and the substrate 100 may be disposed on a side of the first doping layer 110. Preferably, the first doping layer 110 may at least partially surround the radiation source 200, and the substrate 100 may at least partially surround the first doping layer 110. Herein, the substrate 100 may include a second doping layer 120 doped with impurities. The second doping layer 120 may face the first doping layer 110, i.e., may be arranged next to the first doping layer 110. In this case, the second doping layer 120 may at least partially surround the first doping layer 110.

The second doping layer 120 may have an opposite conductivity type to the first doping layer 110. That is, the first doping layer 110 may be doped to show a first conductivity type, whereas the second doping layer 120 may be doped to show a second conductivity type. Preferably, the first doping layer 110 and the second doping layer 120 may form a homojunction. Alternatively, the first doping layer 110 and the second doping layer 120 may form a heterojunction.

Optionally, the substrate 100 may have a non-doping region 109 that is not doped with dopants. The non-doping region 109 may refer to a region with a concentration of dopants below a certain level, rather than a region completely devoid of dopants. For example, the dopant concentration in the non-doping region 109 may be less than 1E15 cm⁻³.

For example, the dopant of the first conductivity type may be an n-type dopant and the dopant of the second conductivity type may be a p-type dopant. Alternatively, the dopant of the first conductivity type may be a p-type dopant and the dopant of the second conductivity type may be an n-type dopant. Generally, the first and second regions 110, 120 may be of different conductive types. One of ordinary skill in the art will understand that depending on the conductivity type of the doped dopants in each region, one of the first doping layer 110 and the second doping layer 120 may act as a cathode and the other may act as an anode. That is, if the dopants of the first conductivity type are n-type dopants and the dopants of the second conductivity type are p-type dopants, the first doping layer 110 may act as an anode and the second doping layer 120 may act as a cathode. Conversely, if the dopant of the first conductivity type is a p-type dopant and the dopant of the second conductivity type is an n-type dopant, the first doping layer 110 may act as a cathode and the second doping layer 120 may act as an anode.

The region doped with the n-type dopant may be, for example, a semiconductor, silicon, or diamond region doped with nitrogen (N), phosphorus (P), arsenic (As), or antimony (Sb), which are 15^{th} group (or nitrogen group) elements of the periodic table, or it may be a compound semiconductor doped with nitrogen (N), phosphorus (P), arsenic (As), or antimony (Sb), which are 15^{th} group (or nitrogen group) elements of the periodic table. As used herein, a compound semiconductor refers to a semiconductor composed of two or more elements and may be, for example, silicon carbide, silicon oxide, aluminum phosphide (AlP), aluminum arsenide (AlAs), gallium arsenide (GaAs), or gallium nitride (GaN).

The p-type doped region may be a semiconductor, silicon, or diamond region doped with any of the boron group elements of the periodic table, such as boron (B), aluminum (Al), gallium (Ga), or indium (In), or may be a compound semiconductor doped with any of the boron group elements of the periodic table, such as boron (B), aluminum (Al), gallium (Ga), or indium (In), which are 13th group elements of the periodic table.

When the first doping layer 110 and the second doping layer 120 form a homojunction, a material having a chemical formula of AMO3 described above may be used as the first doping layer 110 and the second doping layer 120. In this case, hydrogen (H), nitrogen (N), and the like may be used as p-type dopants, and lanthanum (La), indium (In), tin (Sn), and the like may be used as n-type dopants.

Optionally, the first doping layer 110 and the second doping layer 120 may include an organic (or organic material) used in organic layers that receive light to generate power, such as in solar cell applications. For example, the first doping layer 110 and the second doping layer 120 may include a thiophene-like compound. Meanwhile, the first doping layer 110 and the second doping layer 120 may be inorganic-organic hybrids, comprising any suitable mix of inorganic and organic materials described above.

A depletion region may be formed near the interface where the first doping layer 110 and the second doping layer 120 make contact with each other.

The embodiment illustrated in FIG. 2b differs from the embodiment described with reference to FIG. 2a in that the non-doping region 109 of the substrate 100 is not present. Accordingly, the following description will focus on this difference and omit redundant descriptions.

Referring to FIG. 2b, the substrate 100 may be doped with a dopant throughout the entirety of the substrate 100 at or above a certain concentration, such that the entire substrate 100 may substantially coincide with the second doping layer 120. The dopant may be doped at a concentration of, for example, about 1E16 cm⁻³ to about 5E19 cm⁻³.

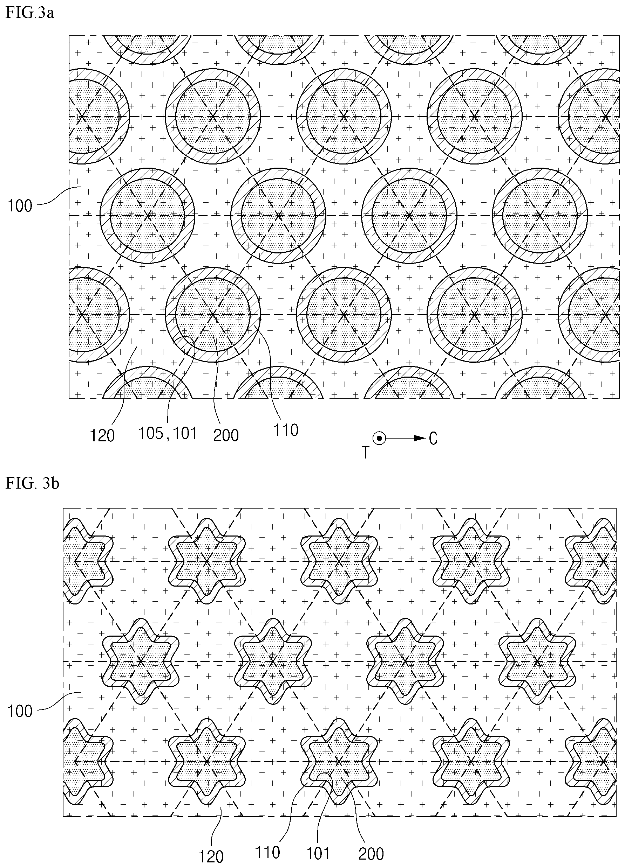

Preferably, the radiation source 200 may be provided within a through-hole provided in the substrate 100. FIG. 3a to 3c are plan views illustrating the configuration in which a plurality of the radiation sources 200 is disposed within the through-hole 101, according to various embodiments of the present invention.

Referring to FIG. 3a, the substrate 100 may be provided with a plurality of through-holes 101 extending from the top major surface to the bottom major surface of the substrate 100, and the radiation source 200 may be disposed within the through-holes 101.

The through-holes 101 may be formed by any method known to those of ordinary skill in the art. For example, the through-holes 101 may be formed by anisotropic etching, isotropic etching, laser irradiation, or the like. In some embodiments, the through-holes 101 may be formed by irradiating the substrate 100 with laser light. In some embodiments, the through-holes 101 may be formed by reactive ion etching (RIE).

The through-holes 101, as shown in FIG. 3a, may have a circular cross-section. Alternatively, the through-holes 101 may have a cross-section of a regular polygon, e.g., a triangle, a rectangle, a pentagon, a hexagon, etc. Generally, however, a plurality of cavities 105 of different configurations may be provided within the substrate, irrespective of whether the cavity 105 extends completely through the substrate 100.

Optionally, the through-holes 101 may be arranged with a predetermined regularity or pattern. For example, the through-holes 101 may be disposed such that their respective centers are located at the vertices of a series of imaginary equilateral triangles, as exemplarily shown in FIG. 3a (e.g., a two-dimensional (2D) hexagonal lattice). In some implementations, other arrangements of the through-holes 101 can be used such as square lattice, rectangular lattice, non-lattice arrangements, and the like.

By arranging the through-holes 101 so that their centers are located at the vertices of the imaginary equilateral triangles, the number of radiation sources 200 that can be accommodated per unit area can be maximized. Therefore, energy density of the isotope battery can be further increased.

Generally, the first doping layer 110 may be disposed to surround the radiation sources 200 at least partially. For example, the first doping layer 110 may surround an outer circumference of the radiation source 200, as exemplarily shown in FIG. 3a. In a more general example, the first doping layer 110 may be disposed within or around the cavity 105 and extend along at least a section of the circumference of the cavity 105.

The second doping layer 120 may be disposed to surround the first doping layer 110 at least partially. For example, the first doping layer 110 may be disposed in the form of frames surrounding the respective cavities 105, and a part of the semiconductor substrate 100 may be formed with the second doping layer 120. Alternatively, the second doping layer 120 may be disposed in the form of frames surrounding the respective first doping layer 110.

Referring to FIG. 3b, the side walls of the through-holes 101 may have irregularities. That is, the circumference of the through-holes 101 may have concave portions and convex portions. The interface between the radiation source 200 and the first doping layer 110 may have irregularities. Preferably, the interface between the first doping layer 110 and the second doping layer 120 may have irregularities.

The first doping layer 110 may have a substantially constant lateral thickness as shown in FIG. 3b. Accordingly, the interface between the first doping layer 110 and the second doping layer 120 may have a shape corresponding to the interface between the radiation source 200 and the first doping layer 110.

Since the side walls of the through-holes 101 have irregularities, the contact area between the radiation source 200 and the first doping layer 110 can increase, thus improving the efficiency of the radiation source 200. Additionally, since the interface between the first doping layer 110 and the second doping layer 120 has a corrugated shape, the contact area between the first doping layer 110 and the second doping layer 120 increases, thereby improving the efficiency of the isotope battery 1.

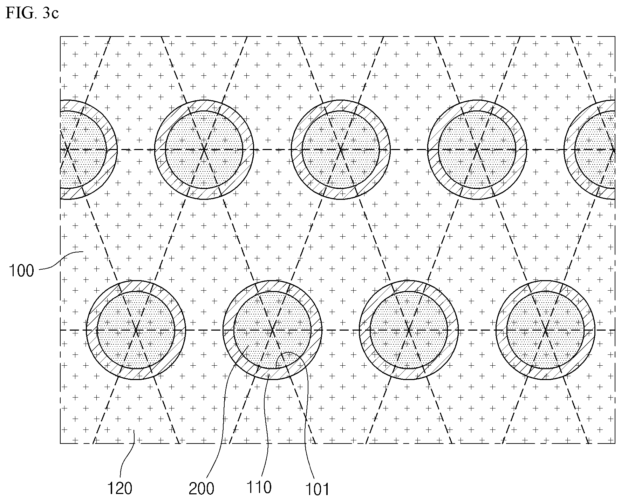

Referring to FIG. 3c, the centers of the through-holes 101 may be arranged such that they are positioned at the vertices of a series of virtual isosceles triangles. As shown in FIG. 3c, the centers of the through-holes 101 need not necessarily be positioned exactly at the vertices of the equilateral triangles. Alternatively, the triangles, at whose vertices the centers of the through-holes 101 are positioned, may have different shapes from each other. In this case, the through-holes 101 may be arranged somewhat irregularly.

As discussed above, the cavity 105 may be realized as a through-hole 101. However, the invention is not limited to this configuration. For example, the cavity 105 may also be a recess with a closed bottom. Otherwise, the cavity 105 may be in the form of a longitudinal opening, e.g., a slit or a trench, having a longitudinal extension in at least one direction on the first - or top major - surface of the substrate. The longitudinal opening may as well extend through the entire thickness of the substrate or not.

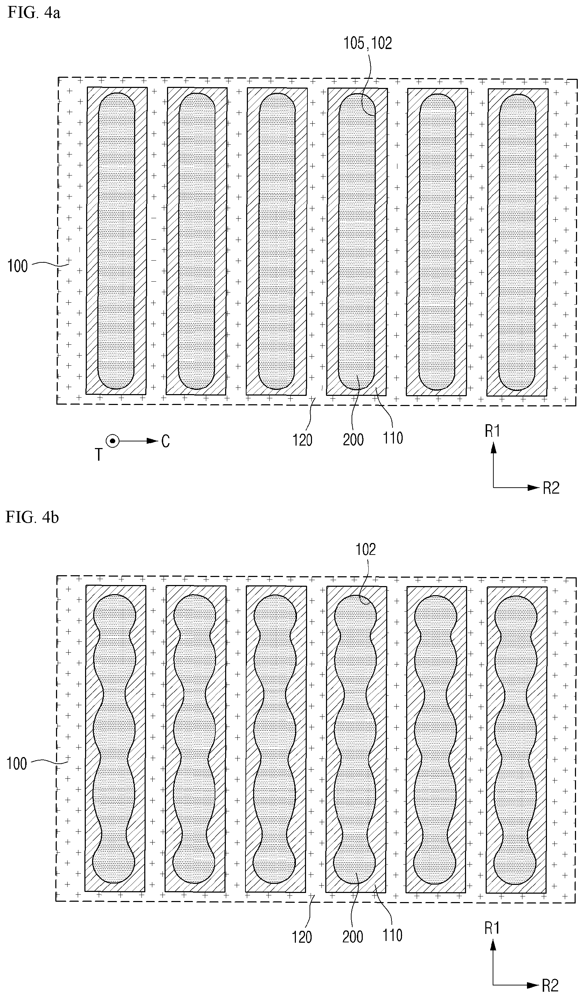

FIG. 4a is a plan view exemplarily illustrating how the radiation source 200 may be disposed within the cavity 105 formed as a longitudinal opening, or a slit 102.

Referring to FIG. 4a, the substrate 100 may include a plurality of slits 102 extending in parallel in one direction. Further, a radiation source 200 may be disposed within each of the slits 102. As shown in FIG. 4a, the cavity 105 may have a longitudinal extension in a first direction R1 which is greater than a width of the cavity 105 in a second direction R2, wherein the first direction is perpendicular to the substrate thickness direction T, and the second direction R2 is perpendicular to both the substrate thickness direction T and the first direction R1.

Preferably, at least a side of the radiation source 200 may contact at least a side of the slit 102. Generally, the radiation source 200 may be in contact with a circumference of the slit 102.

Optionally, the first doping layer 110 may be disposed to face a longitudinally extended side of the radiation source 200. Preferably, the first doping layer 110 may face both sides of the longitudinal extension of the radiation source 200. For example, the first doping layer 110 may extend along two longitudinal sides of the cavity 105 extending in the first direction R1. More preferably, as exemplarily shown in FIG. 4, the first doping layer 110 may completely surround the longitudinally extending cavity 105. Generally, the first doping layer 110 may be disposed to surround the radiation source 200 either completely or at least partially.

The second doping layer 120 may be disposed to face a longitudinally extended side of the first doping layer 110. For example, the second doping layer 120 may extend along the part of the first doping layer 110 which extends along the longitudinal side of the cavity 105. More preferably, as exemplarily shown in FIG. 4, the second doping layer 120 may completely surround the first doping layer 110. Generally, the second doping layer 120 may be disposed to surround the first doping layer 110 either completely or at least partially. Referring to FIG. 4b, longitudinal extensions, or side walls, of the slits 102 may have irregularities. That is, the longitudinal extensions of the slits 102 may have concave and convex portions. Thus, the interface between the radiation source 200 and the first doping layer 110 may have irregularities.

Since the longitudinal extensions, or side walls of the slits 102 have irregularities, a contact area between the radiation sources 200 and the first doping layer 110 can be increased, thereby improving efficiency of the radiation source 200.

In FIGS. 1 to 4b, the entire portion that is not the first doping layer 110 of the substrate 100 is shown as the second doping layer 120, but the present invention is not limited thereto. In some embodiments, regions of different conductive types or dopant concentrations may be present within the substrate 100, or regions may be present that are not doped with a particular conductive type (i.e., non-doping region 109), as shown in FIG. 2a. In some embodiments, the substrate 100 may have a dopant concentration below a certain concentration or may not be doped with dopants. In this case, the substrate 100 may be substantially an electrical insulator.

Referring back to FIG. 1, the plurality of isotope electrode sheets 10 stacked on top of one another may have an identical configuration, obtained from an identical semiconductor dies.

As further exemplarily shown in FIG. 1, each of the isotope electrode sheets 10 may include a first upper electrode 132, which may be provided on the upper part of the first doping layer 110, e.g., on the top major surface of the substrate 100. Additionally or alternatively, the isotope electrode sheet 10 may include a first lower electrode 152, which may be provided on the lower part of the first doping layer 110, e.g., on the bottom major surface of the substrate 100. Generally, the first upper electrode 132 may be in electrical contact with the first doping layer 110 at the first surface, and the first lower electrode 152 may be in contact with the first doping layer 110 at the second surface.

Further, each of the isotope electrode sheets 10 may include a second upper electrode 134, which may be provided on the upper part of the second doping layer 120, e.g. on the top major surface of the substrate 100, and a second lower electrode 154 , which may be provided on the lower part of the second doping layer 120, e.g., at the bottom major surface of the substrate 100.

Each of the first upper electrode 132, the first lower electrode 152, the second upper electrode 134, and the second lower electrode 154 may act substantially as a current collector. Each of the first upper electrode 132, the first lower electrode 152, the second upper electrode 134, and the second lower electrode 154 is not particularly limited in type, size, and shape as long as it is electrically conductive without causing physical and chemical changes to the isotope electrode sheets 10. For example, each of the first upper electrode 132, the first lower electrode 152, the second upper electrode 134, and the second lower electrode 154 may be cylindrical, tetrahedral, hexahedral, torus, or pad-shaped. Furthermore, each of the first upper electrode 132, the first lower electrode 152, the second upper electrode 134, and the second lower electrode 154 may have a hollow center portion.

Further optionally, at the first surface, the second upper electrode 134 may, for example, be a continuous layer comprising openings arranged corresponding to the first doping layers 110, and the first upper electrodes 132 may be positioned in said openings. Similarly, at the second surface, the second lower electrode 154 may, for example, be a continuous layer comprising openings arranged corresponding to the first doping layers 110, and the first lower electrodes 152 may be positioned in said openings.

Each of the first upper electrode 132, the first lower electrode 152, the second upper electrode 134, and the second lower electrode 154 may include, for example, a metallic material such as gold (Au), silver (Ag), platinum (Pt), stainless steel, copper (Cu), aluminum (Al), nickel (Ni), or titanium (Ti), a transparent oxide such as fluorine (F)-doped tin oxide (FTO) or indium tin oxide (ITO, In₂O₃/SnO₂), or a carbon-based compound such as carbon nanotubes, graphene, or graphene oxide.

The radiation source 200 may include a radioactive isotope that emits beta rays. For example, the radiation source 200 may include one or more selected from a group consisting of tritium (³H, tritium), calcium-45 (⁴⁵Ca), nickel-63 (⁶³Ni), copper-67 (⁶⁷Cu), strontium-90 (⁹⁰Sr), promethium-147 (¹⁴⁷Pm), osmium-194 (¹⁹⁴OS), thulium-171 (¹⁷¹Tm), tantalum-182 (¹⁸²Ta), cadmium-115 (¹¹⁵Cd), germanium-75 (⁷⁵Ge), cerium-141 (¹⁴¹Ce), cerium-144 (¹⁴⁴Ce), and tungsten-185 (¹⁸⁵W). However, the present invention is not limited to these.

Meanwhile, radioactive isotopes may emit only beta rays, or may emit beta rays, including alpha rays, gamma rays, or the like.

Alternatively, the radiation source 200 may include a radioactive isotope that emits alpha rays. For example, the radiation source 200 may include one or more selected from a group consisting of americium-241 (²⁴¹Am), americium-243 (²⁴³Am), polonium-209 (²⁰⁹Po), polonium-210 (²¹⁰Po), plutonium-238 (²³⁸Pu), plutonium-239 (²³⁹Pu), curium-242 (²⁴²Cm), curium-244 (²⁴⁴Cm), curium-249 (²⁴⁹Cm), promethium-147 (¹⁴⁷Pm), uranium-238 (²³⁸U), thorium-232 (²³²Th), radium-226 (²²⁶Ra), bismuth-210 (²¹⁰Bi), neptunium-237 (²³⁷Np), europium-152 (¹⁵²Eu), francium-223 (²²³Fr), astatine-210 (²¹⁰At), protactinium-231 (²³¹Pa), einsteinium-253 (²⁵³Es), californium-252 (²⁵²⁰Cf), and berkelium-249 (²⁴⁹Bk). However, the present invention is not limited to these.

The radiation source 200 may be formed by any method known to those skilled in the art. For example, the radiation source 200 may be formed by various methods such as plating, vapor deposition, atomic layer deposition (ALD), etc.

Otherwise, the radiation source 200 may be formed by plating. When the radiation source 200 is formed by plating, a seed layer may be formed, followed by electroplating to form the radiation source 200. Optionally, the radiation source 200 may also be formed by electroless plating.

The first lower electrode 152 of a respective isotope electrode sheet 10 may be electrically connected to the first upper electrode 132 of another isotope electrode sheet 10 positioned directly underneath. Optionally, the first lower electrode 152 of the isotope electrode sheet 10 stacked on top and the first upper electrode 132 of the isotope electrode sheet 10 disposed directly underneath may be connected by a connector 140, for example, a solder ball.

The connector 140 may include a conductive material. Here, the conductive material may include one or more selected from the group consisting of, for example, tin (Sn), indium (In), bismuth (Bi), antimony (Sb), copper (Cu), silver (Ag), zinc (Zn), and lead (Pb). The number, spacing, arrangement, and shape of the connectors 140 may be varied by design without limitation to those shown. Referring to FIG. 1, the connectors 140 may have the form of solder balls or solder bumps.

The space between two vertically neighboring isotope electrode sheets 10 may be filled with an insulating layer 160. The insulating layer 160 is not particularly limited as long as it is any material having electrically insulating properties, and may include for example, one or more selected from the group consisting of a silicate (e.g., TEOS), silicon nitride (SiN), or hafnium oxide, hafnium silicon oxide, hafnium aluminum oxide, lanthanum oxide, lanthanum aluminum oxide, and zirconium oxide, zirconium silicon oxide, tantalum oxide, titanium oxide, barium strontium titanium oxide, barium titanium oxide, barium titanium oxide, strontium titanium oxide, yttrium oxide, aluminum oxide, strontium titanium oxide, yttrium oxide, and aluminum oxide. Alternatively, the insulating layer 160 may be a passivation layer, or the stack-type isotope battery may include a passivation layer in addition to the insulating layer 160.

The isotope battery 1 shown in FIG. 1 can be obtained by manufacturing individual isotope electrode sheets 10 and then stacking them on top of one another. By manufacturing individual isotope electrode sheets 10 and then stacking, defective isotope battery sheets 10 can be selectively excluded and dumped during the course of stacking, thereby improving the yield of the isotope battery 1 and reducing manufacturing costs.

The plurality of isotope electrode sheets 10 may be stored within a housing 190. The plurality of isotope electrode sheets 10 may also be electrically connected to an external load by conductors drawn out to the outside through the housing 190.

According to the present invention, the housing 190 may further include an electromagnetic interference (EMI) shield (not shown) capable of shielding electromagnetic waves. The EMI shield may be formed on at least a portion of an inner surface and/or an outer surface of the housing 190. The EMI shield may include, for example, a metal such as copper, aluminum, a conductive polymer such as polyaniline, or a magnetic material such as iron oxide. The EMI shield may also be provided in the form of a sheet, mesh, applied layer, spray coating, non-woven fabric, tape, or fabric layer. By thoroughly providing the EMI shield on the housing 190, the electromagnetic compatibility (EMC) of the stack-type isotope battery 1 can be ensured. In addition, the EMI shield can prevent or otherwise restrict beta ray or other radiation (e.g., alpha rays or gamma rays) from exiting the housing 190.

The first upper electrodes 132 of the isotope electrode sheet 10 disposed at the uppermost part of FIG. 1 may be electrically connected to each other and electrically connected to a first outer electrode 15a of first polarity. Further, the second lower electrodes 132 of the isotope electrode sheet 10 disposed at the lowermost part of FIG. 1 may be electrically connected to a second outer electrode 15b of a second polarity. The first outer electrode 15a and second outer electrode 15b may be exposed to the outside of the housing 190 for connection to an external load.

Optionally, the second lower electrodes 154 of the isotope electrode sheet 10 disposed at the lowermost part in FIG. 1 may be electrically connected to each other by surrounding the first lower electrodes 152. For example, as already described above, the second lower electrodes 154 may be realized as a continuous layer with openings. Alternatively, the second lower electrodes 154 may be electrically connected to each other by separate conductive lines (not shown) and to the second outer electrode 15b exposed outside the housing 190. The external load to which the first outer electrode 15a and the second outer electrode 15b are connected can include an electronic device, an electro-chemical battery, an energy storage device, or other devices. In operation, the isotope battery according to the present invention has many p-n junctions in parallel, so that the output electrical current flowing through the first outer electrode 15a and the second outer electrode 15b is a sum of the individual currents of the individual p-n junctions in each of the plurality of isotope electrode sheets 10.

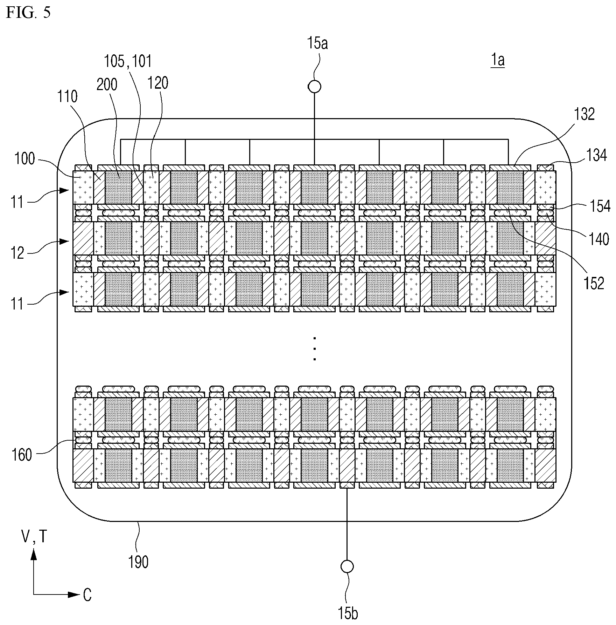

FIG. 5 is a side cross-sectional view illustrating another isotope battery 1a.

Referring to FIG. 5, isotope electrode battery 1a may include a plurality of first isotope electrode sheets 11 and a plurality of second isotope electrode sheets 12 alternately and repeatedly stacked.

Since the first isotope electrode sheet 11 is substantially the same as the isotope electrode sheet 10 described with reference to FIG. 1, a detailed description thereto is omitted here.

The second isotope electrode sheet 12 differs from the first isotope electrode sheet 11 in that the conductive types of the dopants is reversed. That is, if the first doping layer 110 of the first isotope electrode sheet 11 is p-type doped, the first doping layer 110 of the second isotope electrode sheet 12 may be n-type doped. Conversely, if the first doping layer 110 of the first isotope electrode sheet 11 is n-type doped, the first doping layer 110 of the second isotope electrode sheet 12 may be p-type doped.

Similarly, if the second doping layer 120 of the first isotope electrode sheet 11 is p-type doped, the second doping layer 120 of the second isotope electrode sheet 12 may be n-type doped. Conversely, if the second doping layer 120 of the first isotope electrode sheet 11 is n-type doped, the second doping layer 120 of the second isotope electrode sheet 12 may be p-type doped.

In the isotope battery 1a of FIG. 5, the first and second isotope electrode sheets 11, 12 are connected electrically in series, whereas in the battery of FIG. 1, the isotope electrode sheets 10 are connected electrically in parallel. Therefore, the isotope battery 1a shown in FIG. 5 can obtain a higher voltage of electrical energy because a number of individual radiation sources 200 and individual p-n junctions are respectively connected in series. The first outer contact 15a and the second outer contact 15b can have a higher operating voltage than in the beta battery 1 of FIG. 1 because in FIG. 5, the p-n junctions are connected in series so that the overall output voltage is the sum of the individual p-n junction voltages.

Optionally, the current collected by the p-n junctions in the beta battery 1a may follow a meandering path.

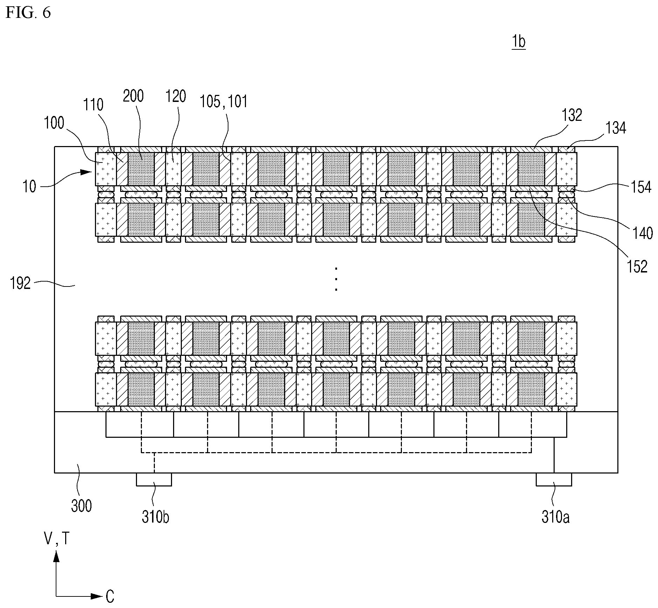

FIG. 6 is a side cross-sectional view illustrating a further isotope battery 1b.

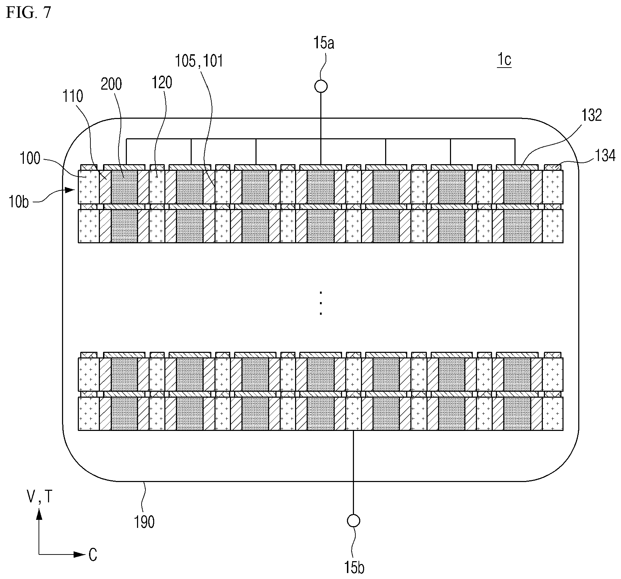

The isotope battery 1b illustrated in FIG. 6 is substantially the same as the isotope battery 1 described with reference to FIG. 1, but differs in that the plurality of isotope electrode sheets 10 are enclosed by or embedded in a molding member 192 and the plurality of isotope electrode sheets 10 are mounted on a controller chip 300. Accordingly, the following description will focus on these differences and omit the description of the common parts. It should be understood that any of the isotope batteries 1, 1a of FIGS. 1 to 5 as well as any one of the isotope batteries of FIGS. 7 to 8, which are described below, may also be mounted on a controller chip 300 and/or embedded in a molding member 192.

Referring to FIG. 6, the plurality of isotope electrode sheets 10 are mounted on a controller chip 300. For example, the controller chip 300 may include a power management integrated circuit (PMIC) that outputs electrical energy generated by the plurality of stacked isotope electrode sheets 10 to an external load (e.g., an energy storage device, a capacitor, an electrochemical battery, a lithium-ion battery, etc.) according to predetermined rules.

The plurality of isotope electrode sheets 10 may be molded with a molding member 192. The molding member 192 may include, for example, an epoxy molding compound (EMC).

The first upper electrode 132 and second upper electrode 134 of the uppermost isotope electrode sheet 10 may serve as dummy electrodes when the plurality of isotope electrode sheets 10 are electrically connected to the controller chip 300 through the first and second lower electrodes 152, 154 provided on the lowermost isotope electrode sheet 10, as exemplarily shown in FIG. 6. Optionally, at least one of the first upper electrode 132 and the second upper electrode 134 disposed on the uppermost isotope electrode sheet 10 may be exposed to the outside through the molding member 192. During the EMC molding process, these electrodes 132, 134 may contact the molding die, so as to be finally exposed from the EMC molding member.

Alternatively, the first upper electrode 132 and the second upper electrode 134 disposed on the uppermost isotope electrode sheet 10 may be completely covered by the molding member 192. Alternatively, the upper surface of the topmost isotope electrode sheet of the plurality of sheets 10 lacks both the first upper electrode 132 and the second upper electrode 134 and is instead covered by a passivation layer or by the molding member 192 or by both the passivation layer and the molding member 192.

The electrical energy generated by the plurality of isotope electrode sheets 10 may be supplied to an external load via external terminals 310a, 310b provided on the controller chip 300. In FIG. 6, the plurality of isotope electrode sheets 10 are shown to be mounted on the upper part of the controller chip 300, but the present invention is not limited thereto.

FIG. 7 is a side cross-sectional view illustrating a further isotope battery.

Referring to FIG. 7, the isotope battery 1c may include a plurality of isotope electrode sheets 10b stacked in the vertical direction V, or the substrate thickness direction.

The isotope electrode sheets 10b differ from the isotope electrode sheets 10 of FIG. 1 in that the lower electrodes 152, 154 and the connector 140 are omitted. Therefore, the following description will focus on these differences and omit description of the common parts.

The isotope electrode sheet 10b includes a first upper electrode 132 and a second upper electrode 134 on the upper surface. Optionally, the plurality of stacked isotope electrode sheets 10b may all be of an identical configuration, having been obtained from identical semiconductor dies.

The first upper electrode 132 and the second upper electrode 134 of the isotope electrode sheet 10b lying underneath may be in direct contact with the bottom surfaces of the first doping layer 110 and the second doping layer 120 of another isotope electrode sheet 10b disposed directly on top. In other words, on a respective isotope electrode sheet 10b, first upper electrodes 132 and second upper electrodes 134 may only be provided on the first - or top major - surface of the semiconductor substrate 100, and the second - or bottom major - surface of a semiconductor substrate 100 of a respective isotope electrode sheet 10b may be in electrical contact with the electrodes 132, 134 provided on the first - or top major - surface of the semiconductor substrate 100 of a isotope electrode sheet 10b arranged directly thereunder.

The isotope battery 1c can be more compactly configured since the lower electrodes 152, 154 and the connector 140 are omitted, thereby increasing the energy density.

Further optionally, first doping layers 110 of neighboring isotope electrode sheets 10b and the second doping layers 120 of neighboring isotope electrode sheets may be disposed in direct contact with each other, thus, omitting any electrodes between neighboring isotope electrode sheets within the stack.

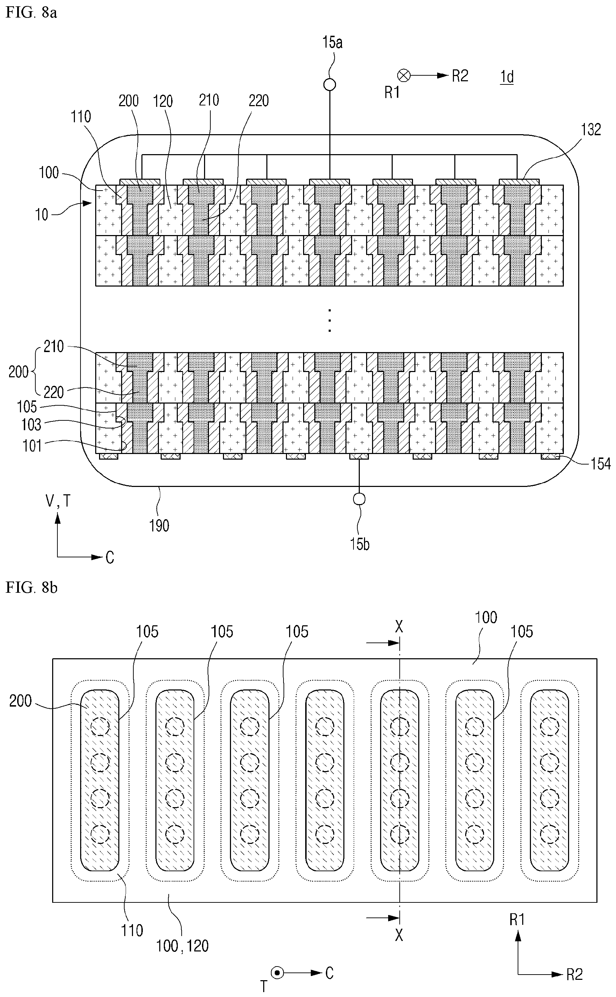

FIG. 8a is a side cross-sectional view illustrating a further isotope battery 1d.

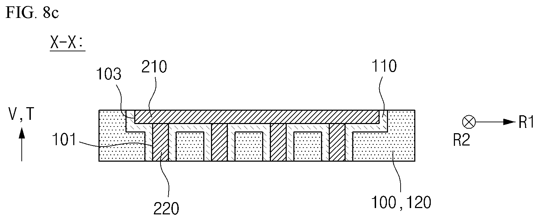

Referring to FIG. 8a, the isotope battery 1d may include a plurality of stacked isotope electrode sheets 10c. FIG. 8b is a plan view of an isotope electrode sheet of the isotope battery of FIG. 8a. FIG. 8c is a cross-sectional view along line X-X of FIG. 8b.

The isotope electrode sheets 10c shown in FIGS. 8a, 8b and 8c differ from those shown in FIG. 1 mainly in the configuration of the cavity 105. As exemplarily shown in FIG. 8a, the cavity 105 has a shape of a stepped recess. The cavity 105 may comprise a trench or recess 103 formed in the first - or top major - surface of the substrate 100. In addition, one or more through-holes 101 may extend between a bottom of the recess 103 and the second - or bottom major - surface of the substrate 100.

That is, the isotope electrode sheets 10c may include a recess 103 extending along an upper surface of the substrate 100 and a through-hole 101 extending from a bottom surface of the recess 103 toward a lower surface of the substrate 100. As exemplarily shown in FIG. 8b, the recess 103 may extend longitudinally in the first direction R1 and the through-hole 101 may extend vertically from a bottom surface of the recess 103. Optionally, a plurality of through-holes 101 may be arranged along the first direction R1 within a single recess or trench 103, as exemplarily shown in FIGS. 8b and 8c.

Inside the recess 103 and in the plurality of through-holes 101, a radiation source 200 may be provided. The radiation source 200 may include a first portion 210 disposed within the recess 103. Further, the radiation source 200 may include a second portion 220 disposed within the through-hole 101, extending from the bottom of the recess 103 to the second - or bottom major - surface of the substrate 100.

Preferably, the thickness of the recess 103 may be in a range of about 10 % to about 50 % of the thickness of the isotope electrode sheet 10c. In the meantime, the thickness of the through-hole 101 may be in a range of about 50 % to about 90 % of the thickness of the isotope electrode sheet 10c.

The width of the first portion 210 in the second direction R2may be larger than the width of the second portion 220 in the second direction R2. Here, the second direction R2 is perpendicular to the first direction R1. The width in the second direction R2 of the first portion 210 and the corresponding first doping layer 110 may be larger than the width in the second direction R2 of the second portion 220 and the corresponding first doping layer 110.

The first doping layer 110 may have a substantially constant thickness between the surfaces of the radiation sources 200.

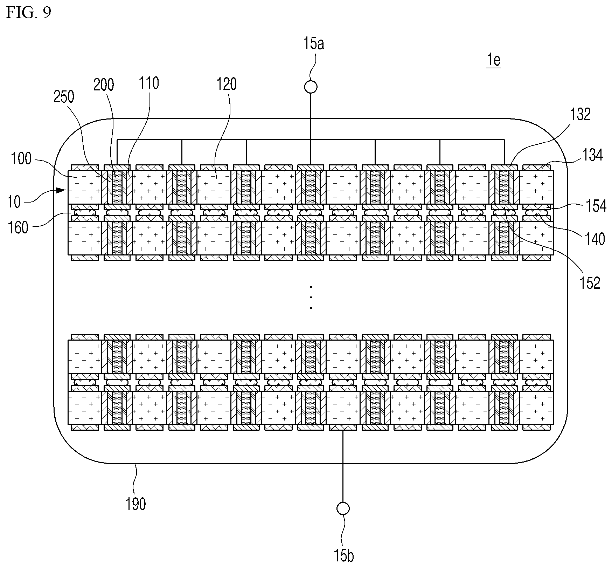

FIG. 9 is a side cross-sectional view illustrating a further isotope battery 1e. The isotope battery 1e of FIG. 9 differs in that it further includes a photon generating layer 250 around the radiation source 200 of the isotope battery 1 shown in FIG. 1a, and this difference will be discussed below.

Referring to FIG. 9, the photon generating layer 250 may be any layer of material capable of emitting photons in response to radiation particles, such as alpha rays, emitted from the radiation source 200. In some embodiments, the radiation source 200 may be a material that emits alpha rays, which has been described with reference to FIG. 1a and will not be described in detail herein.

For example, the photon generating layer 250 may employ materials such as, but not limited to, Ba₂Ca(BO₃)₂, BaHfO₃, BaI₂:Ce, BeO, BaF₂, BaMgF₄, Cs₂LiLuCi₆:Ce, K₂YF₅, KCaF₃, YI₃:Ce, and the like. Various examples of such photon generating layers 250 are disclosed at https://scintillator.lbl.gov/inorganic-scintillator-library/.

The photon generating layer 250 may emit photons in response to alpha rays incident from the radiation source 200. Photons generated by the photon generating layer 250 may be incident on the junction region between the first doping layer 110 and the second doping layer 120, and electrical energy may be generated by the photons.

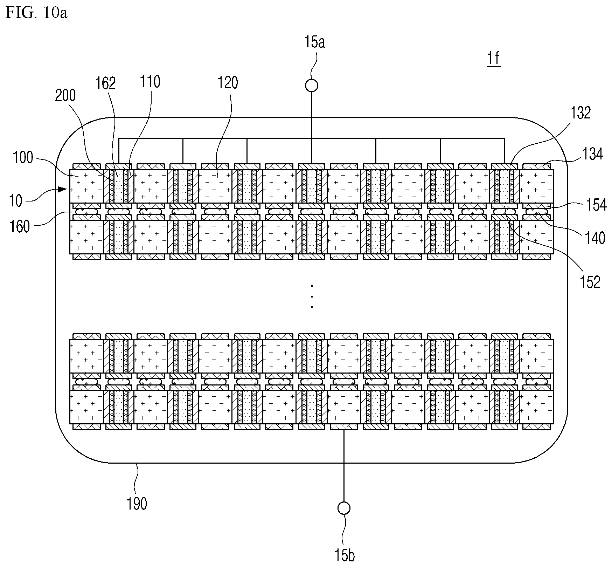

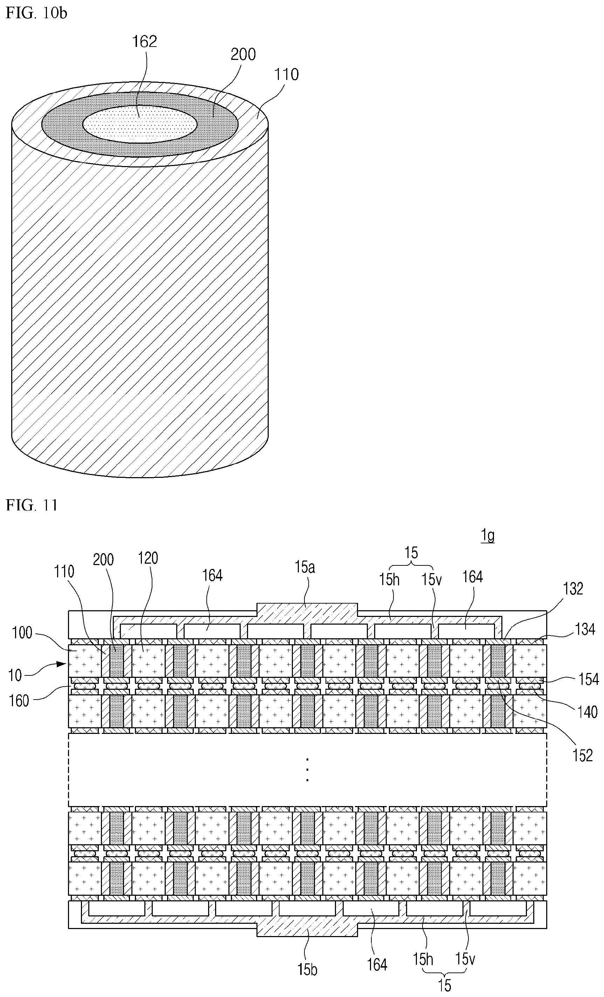

FIG. 10a is a side cross-sectional view illustrating a further isotope battery 1f. FIG. 10b is a partially enlarged perspective view illustrating the first doping layer 110, the radiation source 200, and the insulating layer 162 of the isotope battery 1f. The isotope battery 1f shown in FIGS. 10a and 10b differs from the isotope battery 1 in FIG. 1 in that the radiation source 200 of the isotope battery 1 has an annular shape, and the following discussion will focus on this difference.

Referring to FIGS. 10a and 10b, the radiation source 200 may have a hollow tube shape with a hollow center. In some embodiments, the hollow central portion of the radiation source 200 may be filled by the insulating layer 162. In some other embodiments, the central portion may be filled by the substrate 100 or a semiconductor layer derived therefrom. The radiation source 200 may have a substantially constant thickness and may extend along the interface with the first doping layer 110.

Since the interior of the radiation source 200 is charged by the insulating layer 162, the amount of radiation source required to form the radiation source 200 may be reduced. Since radiation sources are expensive, by forming the annular radiation source 200 in this manner, the isotope battery 1f can be manufactured at a lower cost.

FIG. 11 is a side cross-sectional view illustrating a further isotope battery 1g. The isotope battery 1g shown in FIG. 11 differs from the isotope battery 1 shown in FIG. 1 in that the external electrodes 15a, 15b of the isotope battery 1 are further refined, and the following discussion will focus on these differences.

Referring to FIG. 11, the isotope battery 1g includes a first external electrode 15a and a second external electrode 15b for supplying electrical energy to an external load.

To connect the first external electrode 15a with the first upper electrodes 132 of the isotope electrode sheet 10, conductors 15 extending within an insulator 164 are provided. The conductors 15 may only be electrically connected to the first upper electrodes 132.

In some embodiments, the conductors 15 may comprise a first conductors 15h and a second conductors 15v extending in different directions within the insulator 164. The second conductors 15v may electrically connect the first conductor 15h and the first upper electrodes 132. The first conductor 15h may be physically and/or electrically connected to the first external electrode 15a. In some embodiments, the first conductor 15h may extend in a horizontal direction and the second conductors 15v may extend in a vertical direction, but the invention is not limited thereto.

In some embodiments, the second upper electrode 134 of the isotope electrode sheet 10 closest to the first external electrode 15a may be omitted.

The second external electrode 15b may also be electrically connected to the isotope electrode sheet 10 in a similar manner as the first external electrode 15a. A person of ordinary skill in the art will be able to conceive the wiring connections between the second external electrode 15b and the isotope electrode sheet 10 with reference to the wiring connections between the first external electrode 15a and the isotope electrode sheet 10 described above.

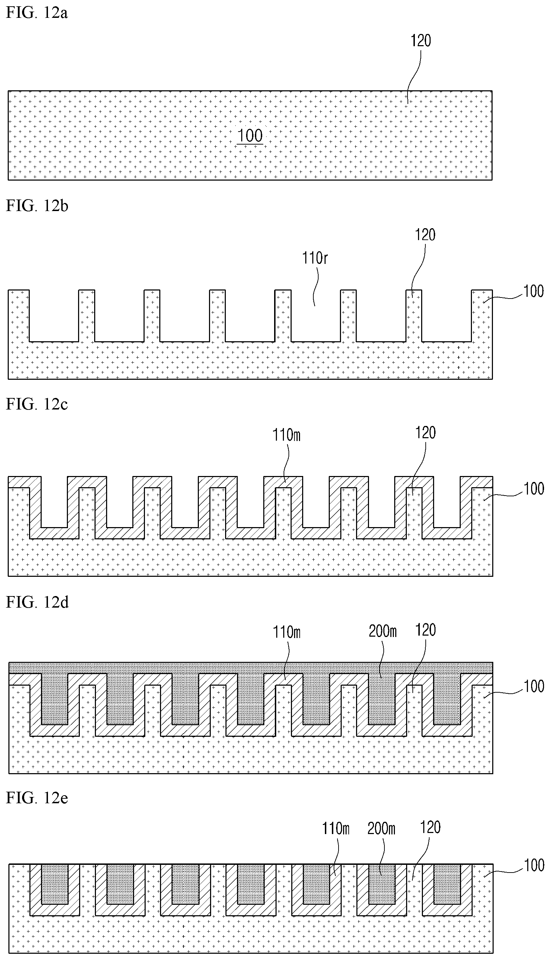

FIGS. 12a to 12h are side views illustrating a method of manufacturing an isotope battery 1.

Referring to FIG. 12a, a substrate 100 is provided. The substrate 100 may include, for example, a material having an energy bandgap of about 2.5 eV or greater. The material of the substrate 100 has been described with reference to FIG. 1 and will not be described in detail herein.

The substrate 100 may be at least partially doped with a dopant. The dopant may be a dopant of a desired conductive type, and may have a conductivity type opposite to that of the dopant doped in the first doping material layer 110m described later.

The dopant may be doped throughout the entirety of the substrate 100, or it may be locally doped to form a well. In some embodiments, there may be regions within the substrate 100 that are not doped with a particular conductivity. The doped regions subsequently may form a second doping layer 120.

Referring to FIG. 12b, a plurality of recesses 100r may be formed in the substrate 100.

The recess 100r may be formed, for example, by deep reactive ion etching (DRIE). However, the present invention is not limited to this. The recess 100r may be in the form of a hole, or may be in the form of a recess extending in the substrate thickness direction.

As previously described, the entire substrate 100 may be doped with a specific conductivity. In this case, the sidewalls of the recess 100r may themselves constitute the second doping layer 120.

Alternatively, the substrate 100 may have a well region doped with a specific conductivity type. For example, the recess 100r may be formed within the well regions, and the sidewalls of the recess 100r formed within the well regions may themselves constitute the second doping layer 120.

In another embodiment, the recess 100r having the second doping layer 120 at its sidewalls may be formed by forming a recess having a greater width and depth than the recess 100r and then epitaxially growing the substrate 100. When epi-growing the substrate 100, the dopant of the desired conductivity type can be doped.

The aspect ratio of the recess 100r can be determined by considering the thickness of the first doping layer 110 to be formed later, the film-forming properties of the radiation source 200, and the like.

Referring to FIG. 12c, a first doping material layer 110m may be formed in the interior of the recess 100r and on the upper surface of the substrate 100 with a predetermined thickness. That is, the first doping material layer 110m may be formed on the upper surface of the substrate 100, covering at least a part of the recess 100r.

The first doping material layer 110m may be formed by any known method. For example, the first doping material layer 110m may be formed by methods such as epitaxy, physical vapor deposition (PVD), chemical vapor deposition (CVD), atomic layer deposition (ALD), etc. However, the present invention is not limited to these. A person of ordinary skill in the art will be able to select an appropriate deposition method, considering the type of material to be deposited, the nature of the precursor or source, the step coverage required, and the like.

The first doping material layer 110m may comprise the same material as the first doping layer 110 described above, which will not be described in detail herein. As described above, the first doping material layer 110m may be doped with dopants of a desired conductivity type. The second doping layer 120 and the first doping material layer 110m may form a p-n junction at least at the sidewalls of the recess 110r. Optionally, the second doping layer 120 and the first doping material layer 110m may form a p-n junction on or along the upper surface of the substrate 100.

The first doping material layer 110m may be formed conformally with the recess 110r. Thus, the recess 110r may have an unfilled, remaining space even after the formation of the first doping material layer 110m.

Referring to FIG. 12d, a radiation source material layer 200m is formed in this unfilled portion of the recess 110r. For example, the radiation source material layer 200m may be formed in the recess 110r, covering or filling at least a part of the unfilled portion of the recess 110r. In FIG. 12d, it is shown that the unfilled portion of the recess 110r is fully covered or filled up with the radiation source material layer 200m, but the present invention is not limited thereto.

Optionally, the radiation source material layer 200m may be formed on the upper surface of the first doping material layer 110m. For example, the radiation source material layer 200m may be formed along the first doping material layer 110m, covering the upper surface of the first doping material layer 110m.

The radiation source material layer 200m may be formed by any known method. For example, the radiation source material layer 200m may be formed by methods such as PVD, CVD, or ALD. However, the present invention is not limited to these methods. A person of ordinary skill in the art will be able to select an appropriate deposition method, considering the type of material to be deposited, the nature of the precursor or source, the step coverage required, and the like.

The radiation source material layer 200m may be made of the same material as the radiation source 200 described above, which will not be described in detail herein.

Referring to FIG. 12e, the radiation source material layer 200m and the first doping material layer 110m are partially removed to expose the upper surface of the substrate 100.

For example, portions of the radiation source material layer 200m and the first doping material layer 110m that are present on the upper surface of the substrate 100 may be removed. Thereby, the upper surface of the substrate 100 may be exposed.

The radiation source material layer 200m and the first doping material layer 110m may be partially removed and leveled by dry etching, wet etching, and/or chemical mechanical polishing (CMP).

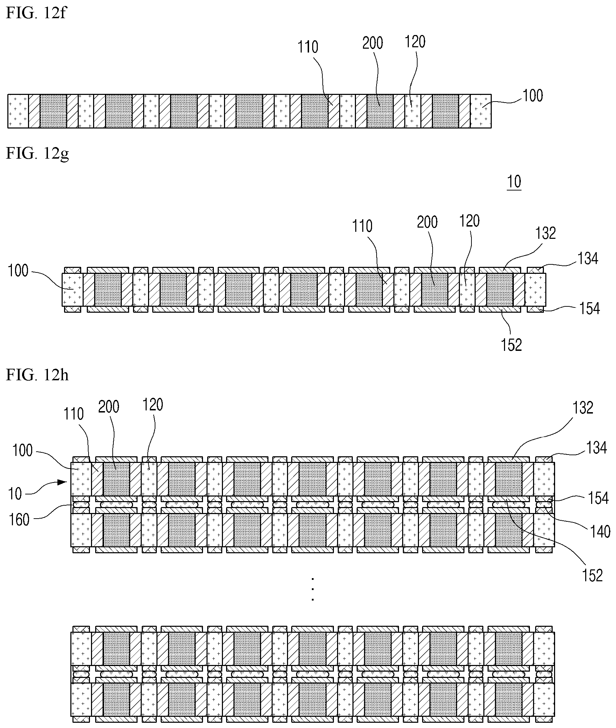

Optionally, referring to FIG. 12f, the lower part of the substrate 100 may be partially removed. For example, the lower surface of the substrate 100 may be removed until the lower surface of the radiation source 200 is exposed.

The lower part of the substrate 100 may be partially removed and leveled by dry etching, wet etching, and/or CMP. As the lower surface of the substrate 100 is removed, the lower part of the first doping material layer 110m and the lower part of the radiation source material layer 200m may be partially removed. By partially removing the lower part of the substrate 100, the radiation source 200 becomes externally exposed and, as a result, the radiation source 200 penetrates the substrate 100, from the top major surface till the bottom major surface.

Furthermore, the first doping layer 110 and the second doping layer 120 are formed by removing the lower surface or lower part of the substrate 100.

Referring to FIG. 12g, a first upper electrode 132 and a first lower electrode 152 may be formed on the upper and lower parts of the first doping layer 110, respectively. In addition, a second upper electrode 134 and a second lower electrode 154 may be formed on the upper and lower part of the second doping layer 120, respectively. As a result, the isotope electrode sheet 10 is formed.

The electrodes 132, 152, 134, 154 may be formed, for example, by electrolytic plating or electroless plating. Optionally, only some of the electrodes 132, 152, 134, 154 may be formed.

Referring to FIG. 12h, the isotope electrode sheet 10 may be repeatedly stacked. The isotope electrode sheets 10 may be stacked in a direction which is parallel with or corresponding to the thickness direction of the isotope electrode sheets 10. The stacked isotope electrode sheets 10 may be electrically connected to each other by connectors 140.

Optionally, an insulator 160 may be provided between two neighboring isotope electrode sheets 10. The insulator 160 may be provided between the isotope electrode sheets 10, which are neighboring in the stacking direction. The insulator 160 has been described above with reference to FIG. 1 and will not be described in detail herein.

Preferably, the plurality of stacked isotope electrode sheets 10 can then be electrically connected and accommodated within a housing 190 to obtain the stack-type isotope battery 1 as shown in FIG. 1.

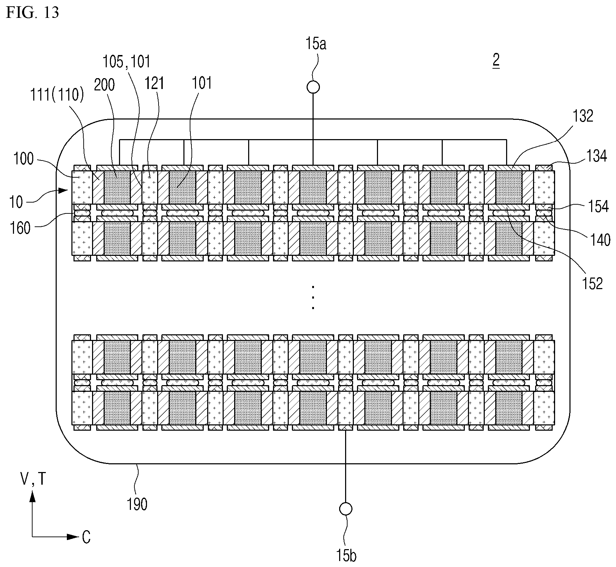

FIG. 13 is a side cross-sectional view illustrating a stack-type capacitor 2 according to one embodiment of the present invention. The stack-type capacitor 2 illustrated in FIG. 13 differs from the isotope battery 1 described with reference to FIG. 1 in that it does not have a second doping layer.

Referring to FIG. 13, a first layer 111 of the first conductivity type may be disposed to surround a side of the radiation source 200 at least partially. The first layer 111 is substantially the same as the first doping layer 110 described with reference to FIG. 1, and therefore will not be described in detail herein.

The first layer 111 may be surrounded by a second layer 121 at least partially. The second layer 121 is substantially the same as the non-doping region 109 described with reference to FIGS. 2a and 2b. That is, the second layer 121 may be a region of the substrate 100 that is not doped with dopants or has a dopant concentration below a predetermined concentration.

The first layer 111 and the second layer 121 may contact each other at an interface. Preferably, the first layer 111 and the second layer 121 may form a homojunction.

The radiation source 200, the first layer 111, and the second layer 121 may form a single capacitor. That is, the radiation emitted from the radiation source 200 may form an electron-hole pair (EHP) at the interface between the first layer 111 and the second layer 121 and form a single unit capacitor.

Although embodiments of the present invention have been described in detail above, one of ordinary skill in the art to which the present invention belongs will be able to make many modifications to the present invention without departing from the scope of the invention as defined in the appended claims. Accordingly, future modifications of the embodiments of the present invention will not depart from the scope of the present invention.

## Claims

1. A stack-type isotope battery (1, 1a, 1b, 1c, 1d, 2) comprising:
a plurality of stacked isotope electrode sheets (10, 10b, 10c, 11, 12), each of the isotope electrode sheets (10, 10b, 10c, 11, 12) including:
a substrate (100) having a first layer (110, 111) and a second layer (120, 121) and a cavity (105) extending in the substrate thickness direction; and
a radiation source (200) accommodated in the cavity (105),
wherein the first layer (110, 111) is interposed between the radiation source (200) and the second layer (120, 121),
wherein the plurality of isotope electrode sheets (10, 10b, 10c, 11, 12) are stacked on top of one another in a direction parallel to the substrate thickness direction; and
a first external electrode (15a) of first polarity and a second external electrode (15b) of second polarity respectively connected to the plurality of stacked isotope electrode sheets (10, 10b, 10c, 11, 12) to provide an electrical connection to an external load,
wherein the substrate (100) has a chemical formula of AMO₃ (where A is one or more selected from the group consisting of La, Ba, Sr, and K, and M is one or more selected from the group consisting of Al, In, Ga, Ti, Sn, Hf, Ta, and Zr), and
wherein the first layer (110, 111) is doped with dopants of a first conductive type and a second layer (120, 121) is either doped with dopants of a second conductive type different from the first conductive type or undoped.

2. The stack-type isotope battery (1, 1a, 1b, 1c, 1d, 2) of claim 1, wherein the substrate (100) has as a main component thereof one or more selected from the group consisting of BaSnO₃, BaHfO₃, BaZrO₃, BaHf₁₋ₓTiₓO₃(where 0<x<1), Ba₁₋ₓLaₓSnO₃(where 0<x<1), Bi₄Ge₃O₁₂, Al₂O₃, Y₂O₃, La₂O₃, Ga₂O₃, Bi₂O₃, ZrO₂, HfO₂, Ta₂O₅, TiO₂, LaInO₃, LaGaO₃, SrZrO₃, SrHfO₃, SrTaO₇, LaIn₁₋ₓGaₓO₃ (where 0<x<1), LaGaO₃, SrTiO₃, KTaO₃, HfSiO₄, Ta₃Ti₂Oₓ, and LaAlO₃.

3. The stack-type isotope battery (1, 1a, 1b, 1c, 1d, 2) of claim 1 or 2, wherein the substrate (100) has BaSnO₃ as the main component.

4. The stack-type isotope battery (1, 1a, 1b, 1c, 1d, 2) of any one of the preceding claims, wherein the first layer (110, 111) and the second layer (120, 121) form a homojunction.

5. The stack-type isotope battery (1, 1a, 1b, 1c, 1d) of any one of the preceding claims, wherein the first layer (110, 111) at least partially surrounds a periphery of the radiation source (200) and the second layer (120, 121) at least partially surrounds a periphery of the first layer (110, 111).

6. The stack-type isotope battery (1, 1a, 1b, 1c, 1d, 2) of any one of the preceding claims, wherein the cavity (105) is a through-hole (101) penetrating the substrate (100).

7. The stack-type isotope battery (1, 1a, 1b, 1c, 1d, 2) of any one of the preceding claims, wherein the cavity (105, 102) has, on a top major surface of the substrate (100), a longitudinal extension substantially greater than a width thereof.

8. The stack-type isotope battery (1, 1a, 1b, 1c, 1d, 2) of any one of the preceding claims, wherein the cavity (105) is provided in plurality.

9. The stack-type isotope battery (1, 1a, 1b, 1c, 1d, 2) of any one of the preceding claims, wherein the plurality of stacked isotope electrode sheets (10, 10b, 10c, 11, 12) have an identical configuration, being obtained from identical semiconductor dies.

10. The stack-type isotope battery (1, 1a, 1b, 1c, 1d, 2) of any one of the preceding claims, wherein the plurality of stacked isotope electrode sheets (10, 10b, 10c, 11, 12) are electrically connected to one another by solder balls.

11. The stack-type isotope battery (1, 1a, 1b, 1c, 1d, 2) of any one of the preceding claims, further comprising a controller chip (300) provided on a side of the plurality of stacked isotope electrode sheets (10, 10b, 10c, 11, 12), being configured for controlling output of electrical energy generated from the plurality of stacked isotope battery sheets (10, 10b, 10c, 11, 12).

12. The stack-type isotope battery (1, 1a, 1b, 1c, 1d, 2) of any one of the preceding claims, wherein the plurality of stacked isotope electrode sheets (10, 10b, 10c, 11, 12) are embedded in a molding resin (192).

13. The stack-type isotope battery (1, 1a, 1b, 1c, 1d, 2) of claim 12, further comprising at least one dummy electrode (132, 134) exposed outside through the molding resin (192).

14. The stack-type isotope battery (1, 1a, 1b, 1c, 1d, 2) of any one of the preceding claims, further comprising a first electrode (132) and a second electrode (134) provided in-between two neighboring ones of the plurality of stacked isotope electrode sheets (10, 10b, 10c, 11, 12),
wherein the first electrode (132) is arranged to provide electrical connection between corresponding first layers (110, 111) of the two neighboring isotope electrode sheets (10, 10b, 10c, 11, 12), and the second electrode (134) is arranged to provide electrical connection between corresponding second layers (120, 121) of the two neighboring isotope electrode sheets (10, 10b, 10c, 11, 12).

15. The stack-type isotope battery (1, 1a, 1b, 1c, 1d, 2) of any one of the preceding claims,
wherein the cavity (105) includes a stepped recess having a first recess (103) at a top major surface of the substrate (100), and a through hole (101) running from a bottom surface of the first recess (103) toward a bottom major surface of the substrate (100), and
wherein the radiation source (200) comprises a first portion (210) disposed in the first recess (103), and a second portion (220) in the through hole (101).
